# EUROPEAN PATENT SPECIFICATION

(11) **EP 2 345 526 B1**
(45) Date of publication and mention of the grant of the patent: **12.02.2014**
(21) Application number: 09816158.1
(22) Date of filing: 24.09.2009
(51) Int. Cl.: B29C 59/02, B29C 33/40, C08G 77/60, H01L 21/027, B29K 83/00

(54) **MOLD FOR NANOIMPRINT**
FORM FÜR NANOIMPRINT
MOULE DE NANOIMPRESSION

(30) Priority: 25.09.2008 JP 2008246101
(43) Date of publication of application: 20.07.2011
(73) Proprietor: Tokyo Institute of Technology, Tokyo 152-8500 (JP); JX Nippon Oil & Energy Corporation, Chiyoda-ku Tokyo 100-8162 (JP)
(72) Inventor: WATANABE Junji, Tokyo 152-8550 (JP); NISHIMURA Suzushi, Yokohama-shi Kanagawa 231-0815 (JP); SEKI Takashi, Yokohama-shi Kanagawa 231-0815 (JP); HIRAI Tomoo, Yokohama-shi Kanagawa 231-0815 (JP)
(74) Representative: Grünecker, Kinkeldey, Stockmair & Schwanhäusser
(86) International application number: PCT/JP2009/066514
(87) International publication number: WO 2010/035743

(56) References cited:
- JP-A- 2004 244 545
- JP-A- 2005 029 694
- JP-A- 2005 036 093
- JP-A- 2005 036 094
- JP-T- 2005 510 436
- JP-T- 2007 524 519

## Description

### Technical Field

The present invention relates to a mold for nanoimprint and a method for fabricating the same, and further, a method for processing a material, using the mold for nanoimprint.

### Background Art

In processes for manufacturing semiconductor integrated circuits, it is required to form ultra-fine patterns of 100 nm to a few tens nanometers in line width. Among the latest field effect transistors, there are some mass produced field effect transistors of 45 nm in gate line width, and developments are advancing toward the industrial realization of the gate line widths of 32 nm or less.

For the purpose of forming such ultra-fine patterns, photolithography has hitherto been frequently used. In photolithography, the KrF excimer laser (krypton fluoride, 248 nm) or the ArF excimer laser (argon fluoride, 193 nm) is used as light source. For further enhancing the fineness, it is necessary to reduce the wavelength of the light source; however, in the present circumstances, it is difficult to perform further reduction of the wavelength of the light source.

Accordingly, nanoimprint has attracted attention as a technique outstripping the limits of photolithography. Nanoimprint is a fine processing technique having recently been remarkably developed, based on the nanoimprint lithography technique proposed in 1995 by Professor Chou of Minnesota University in the United States (Non Patent Literature 1).

The nanoimprint method is a processing method in which a mold having a raised and recessed surface formed in a pattern of required line widths is prepared, and the pattern of the raised and recessed surface is transferred on the surface of an intended material to form the replica of the pattern. As the material of the replica, glass and plastic, etc. are used. Examples of the transfer method include the thermal nanoimprint method in which the shape of the mold is transferred by heating and pressurizing, and the UV nanoimprint method (photo-nanoimprint method) in which an UV curable resin is cast onto the raised and recessed surface of the mold, the resin is cured by light irradiation, and then the cured resin is released from the mold. Additionally, recently room-temperature nanoimprint methods using materials such as HSQ (Hydrogen Silsequioxane) have also been developed.

Molds for nanoimprint are fabricated, for example, by the method in which a predetermined raised and recessed pattern is formed on the surface of a material such as Si, quartz (SiO₂) SiC, Ta, glassy carbon and Ni. For the pattern formation, electron lithography technique, synchrotron radiation lithography technique, EUV lithography technique, and further, electrocasting technique are used.

### Citation List

### Non Patent Literature

[Non Patent Literature 1] Yoshihiko Hirai, "Science and New Technology in Nanoimprint," Frontier Publishing Co., Ltd., July 7, 2006, ISBN4-902410-09-5 C3054.

### Summary of Invention

### Technical Problem

According to conventional lithographic techniques, it is also possible to form a pattern having a resolution as high as about 10 nm. However, there is a problem that the area which a common lithography apparatus can process is an about 8-inch square, and the pattern area which a run of exposure can form is limited to about a 20-cm square. Further, there has been a problem that the drawing time remarkably extends with the increase of the fineness of the pattern, leading to the increase of the production cost.

In other words, in the cases of molds taking advantage of the lithography technique, it has been unrealistic to fabricate the molds having a large-area raised and recessed surface exceeding a 20-cm square, both technically and economically. When processing of larger areas is required, it is possible to use a plurality of molds as joined to each other; however, in this case, it is impossible to avoid the occurrence of failures due to the joints.

Accordingly, the present invention takes as its object the provision of a mold for nanoimprint capable of being easily fabricated without incorporating joints even when the area of the raised and recessed surface for use in transfer is large. The present invention also takes as its another object the provision of a method for fabricating such a mold for nanoimprint.

### Solution to Problem

The present inventors made a diligent effort to solve the above-described problems, consequently have discovered that effective is a method completely different from conventional ones, namely, a method taking advantage of the formation of a raised and recessed structure based on the application of the nature of a liquid-crystalline polysilane to form a smectic phase, and have perfected the present invention on the basis of such knowledge.

Specifically, the present invention relates to a mold for nanoimprint including a liquid-crystalline polysilane and having a raised and recessed surface having a pitch of 1 to 2000 nm formed by the formation of a smectic phase due to the orientation of the liquid-crystalline polysilane.

The mold for nanoimprint according to the present invention is such that the raised and recessed surface is formed on the surface of the mold on the basis of the self-organizing nature of the liquid-crystalline polysilane, hence is such that the area of the raised and recessed surface is not limited as it is in the lithography technique, and can be easily fabricated without incorporating joints even when the area of the raised and recessed surface for use in transfer is large.

For the purpose of efficiently and stably forming the raised and recessed surface, the weight average molecular weight of the liquid-crystalline polysilane is preferably 10000 or more. From the same viewpoint, the liquid-crystalline polysilane is preferably such that the liquid-crystalline polysilane undergoes orientation while forming a helical structure and thus forms a smectic phase.

The mold for nanoimprint according to the present invention may be a metal molded article or a resin molded article having the raised and recessed surface transferred from the raised and recessed surface of the above-described mold for nanoimprint.

In another aspect, the present invention relates to a method for fabricating a mold for nanoimprint. The fabrication method according to the present invention includes: a step of forming a film including a liquid-crystalline polysilane; and a step of obtaining as the mold for nanoimprint the film having a raised and recessed surface having a pitch of 1 to 2000 nm by forming the raised and recessed surface on the surface of the film by orienting the liquid-crystalline polysilane so that a smectic phase is formed and by fixing the orientation of the liquid-crystalline polysilane.

The fabrication method according to the present invention may include: a step of forming a film including a liquid-crystalline polysilane; a step of forming a raised and recessed surface having a pitch of 1 to 2000 nm on the surface of the film by orienting the liquid-crystalline polysilane so that a smectic phase is formed and by fixing the orientation of the liquid-crystalline polysilane; and a step of obtaining as the mold for nanoimprint a metal molded article or a resin molded article having the raised and recessed surface formed by the transfer from the raised and recessed surface on the surface of the film, through forming the metal molded article or the resin molded article on the raised and recessed surface of the film.

According to these methods, it is possible to easily fabricate, without incorporating joints, even a mold for nanoimprint in which the area of the raised and recessed surface for use in transfer is large.

Further, the present invention relates to a processing method for processing a material by the transfer from the raised and recessed surface of any one of the above-described molds for nanoimprint according to the present invention. The processing method according to the present invention makes it possible to easily process even a fine and large processing area into a predetermined pattern while preventing the occurrence of the failure due to joints.

### Advantageous Effects of Invention

According to the present invention, there is provided a mold for nanoimprint capable of being easily fabricated without incorporating joints, even when the area of the raised and recessed surface for use in transfer is large.

### Brief Description of Drawings

Figure 1 is an atomic force micrograph of the surface of the thin film of Example 7.
Figure 2 is an atomic force micrograph of the surface of the thin film of Example 8.
Figure 3 is an atomic force micrograph of the surface of the thin film of Example 9.
Figure 4 is an atomic force micrograph of the surface of the thin film of Example 11.
Figure 5 is an atomic force micrograph of the surface of the thin film of Example 12.
Figure 6 is an atomic force micrograph of the surface of the thin film of Example 13.

### Description of Embodiments

Hereinafter, the preferred embodiment of the present invention is described in detail. However, the present invention is not limited to the following embodiment.

The mold for nanoimprint according to the present embodiment has a raised and recessed surface to be transferred to the surface of a material to be processed. The raised and recessed surface is formed on the basis of the orientation of the liquid-crystalline polysilane constituting the mold for nanoimprint.

The mold for nanoimprint according to the present embodiment is a molded article formed with a liquid crystal material including one or two or more liquid-crystalline polysilanes. The mold for nanoimprint is preferably a film (liquid crystal film) because of the easiness in obtaining a lengthy molded article having a large area.

The liquid-crystalline polysilane constituting the mold is a substance capable of exhibiting a liquid crystalline state by heating or the like. The liquid crystal forms a mesophase having the properties of both liquid and crystal. In other words, the liquid crystal has a feature that the liquid crystal simultaneously has fluidity as liquid and anisotropy as crystal. As liquid crystal substances exhibiting the liquid crystal phase, various substances such as so-called low-molecular-weight liquid crystal substances and polymer liquid crystal substances are known. Such liquid crystal substances have characteristic molecular orientation order depending on the types of the liquid crystal substances and the environment including temperature and the like, and hence can be applied to various purposes by taking advantage of or controlling the molecular orientation thereof. Therefore, the liquid crystal substances industrially form a large field.

On the basis of the molecular shapes and the molecular orientations, liquid crystals are broadly classified into nematic liquid crystal, smectic liquid crystal, discotic liquid crystal and the like. A smectic liquid crystal is a liquid crystal in which a liquid crystal substance having a rod-like mesogen forms a one-dimensional crystal or a layered structure to be referred to as a two-dimensional liquid.

In the mold according to the present embodiment, the liquid-crystalline polysilane is oriented so as for the smectic phase to be formed while forming a rigid rod-like helical structure. It is preferable for the smectic phase formed by the liquid-crystalline polysilane to be fixed in a state substantially having no fluidity. As a result that the orientation of the liquid-crystalline polysilane is fixed, the raised and recessed structure of the mold surface is fixed. With respect to the fact that the liquid-crystalline polysilane forms the rigid rod-like helical structure, there have hitherto been published several reports (Macromolecules, 2002, 35, 4556-4559; J. Am. Chem. Soc., 2000, 122, 3336-3343; Macromolecules, 2007, 40, 648-652). The orientation direction of the liquid-crystalline polysilane may be uniform over the whole mold, may be varied depending on the positions in the mold, or may be varied continuously over the mold.

The smectic phase formed by the liquid-crystalline polysilane may be, for example, any structure selected from the smectic A phase (SmA phase), the smectic B phase (SmB phase), the smectic C phase (SmC phase), the smectic E phase (SmE phase), the smectic F phase (SmF phase), the smectic G phase (SmG phase), the smectic H phase (SmH phase), the smectic I phase (SmI phase), the smectic J phase (SmJ phase), the smectic K phase (SmK phase) and the smectic L phase (SmL phase). From the viewpoints of the easiness in controlling the liquid crystal orientation, the easiness in orientation due to the low viscosity in the liquid crystal state and the like, it is preferable that the smectic A phase is fixed.

In general, the liquid-crystalline polymers forming the smectic phase is packed with the mesogen ends aligned, so as to be oriented along a certain direction. The smectic phase has a structure in which a plurality of liquid crystal molecular layers formed of the packed liquid-crystalline polymer are arranged. It is considered that the raised and recessed surface of the mold is formed on the basis of such an array structure. Theoretically, it is known that the interlayer order of the smectic phase is determined by the excluded volume effect. It is possible to infer that the interlayer distance in the smectic phase is 1.2 to 1.3 times the molecular length of the liquid-crystalline polymer (for example, J. Phys. Soc. Jpn. 1982, 51, 741; J. Chem. Phys. 1997, 106, 666).

As the thermotropic liquid crystal systems, the systems of poly(γ-dodecyl-L-glutamate) and poly(n-decyl-2-methylbutylsilane) each having an extremely precisely uniform molecular weight have been recently reported (for example, Jpn. J. Appl. Phys. 2002, 41, L720-L722; Macromolecules, 2002, 35, 4556-4559; Liquid Crystal, 2004, 31, 279-283). Of these, the polysilane is nonpolar, and hence is hardly susceptible to the effect of the electrostatic intermolecular interaction; therefore, the polysilane tends to exhibit an interlayer distance close to the theoretical prediction based on the excluded volume interaction.

The pitch (the length of one raise/recess period) of the raised and recessed surface of the mold is varied depending on the interlayer distance of the smectic phase. The interlayer distance of the smectic layer increases with the increase of the molecular weight of the liquid-crystalline polysilane. In other words, there is a proportional relation between the molecular weight and the interlayer distance. Therefore, by appropriately selecting the molecular weight of the liquid-crystalline polysilane, it is possible to make the liquid-crystalline polysilane form a raised and recessed surface having an intended pitch. It is also possible to extend the distance between the liquid crystal molecular layers by adopting in the fabrication of the liquid crystal film (mold) the methods such as the following methods: a method in which the liquid-crystalline polysilane is converted into a lyotropic liquid crystal system by addition of an aliphatic solvent; and a method in which the polysilane portion is partially decomposed by UV irradiation after completion of orientation.

The interlayer distance of the smectic phase is not particularly limited, but is preferably 1 to 2000 nm and more preferably 10 to 1000 nm.

The pitch of the raised and recessed surface is usually about 2000 nm or less. More specifically, the pitch of the raised and recessed surface is 1 to 2000 nm. Additionally, the depth of the raised and recessed surface can be varied optionally, and is preferably 10 nm to 10 µm. The mold according to the present embodiment can be easily fabricated on the basis of the control of the weight average molecular weight of the liquid-crystalline polysilane and on the basis of the like, even when the mold has such a fine pattern as described above. The pitch of the raised and recessed surface may be uniform within the mold, but may be varied depending on the positions of the film or may be continuously varied in the film.

The weight average molecular weight of the liquid-crystalline polysilane is usually 1000 or more and preferably 10000 or more. When the weight average molecular weight of the liquid-crystalline polysilane is less than 10000, there is a tendency that it is difficult to utilize the raised and recessed surface as a mold. The weight average molecular weight of the liquid-crystalline polysilane is preferably 2000000 or less. When the weight average molecular weight of the liquid-crystalline polysilane exceeds 2000000, the orientation and the solubility of the liquid crystal molecule are degraded, and hence there is a tendency that it is difficult to fabricate the mold as a thin film.

The liquid-crystalline polysilane is preferably such that the molecular weight distribution represented by the ratio (Mw/Mn) of the weight average molecular weight/the number average molecular weight is 1.00 to 1.60. On the basis of the molecular weight distribution falling within this range, the raised and recessed surface is particularly easily formed. It is possible to obtain the liquid-crystalline polysilane having an intended molecular weight and an intended molecular weight distribution, for example, by a method fractionating the synthesized liquid-crystalline polysilane according to the molecular weight.

The liquid-crystalline polysilane is represented, for example, by the following chemical formula (1):

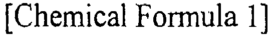

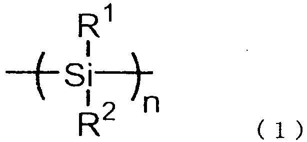

In formula (1), R¹ and R² each independently represent a hydrocarbon group optionally containing an oxygen atom, or each independently represent a halogen atom or a hydrogen atom; a plurality of R¹s and a plurality of R²s in one molecule may be the same as or different from each other; and n represents a positive integer. Depending on the polymerization method, the liquid-crystalline polysilane partially contains the siloxane bond as the case may be. The siloxane bond may be contained to such an extent that does not hinder the development of the smectic phase.

Preferably, R¹ is a hydrocarbon group branched at the β-carbon atom and optionally containing an oxygen atom, and R² is a hydrocarbon group optionally containing an oxygen atom, or is a halogen atom or a hydrogen atom. The liquid-crystalline polysilane in which, as described above, one of the two substituents bonded to the Si atom is branched at the β-position (the position of the second carbon atom from the Si atom) can easily form a rigid rod-like helical structure. More specifically, R¹ is preferably an alkyl group having a methyl group at the β-position thereof (such as a 2-methylbutyl group), and R² is preferably a linear alkyl group (such as an n-decyl group).

When there is chirality in the substituent (R¹ or R²) of the liquid-crystalline polysilane, the liquid-crystalline polysilane formed of one silane compound of the R-isomer and the S-isomer is known to be oriented so as to form a cholesteric phase (Liquid Crystal, 2004, 31, 279-283). In this case, it is possible to form the smectic phase in the temperature region lower than the temperature region adopted to form the cholesteric phase.

The liquid crystal material constituting the mold may contain components other than the liquid-crystalline polymer within ranges that do not remarkably hinder the development of the liquid crystal phase. For example, the liquid crystal material may contain various additives such as a surfactant, a polymerization initiator, a polymerization inhibitor, a sensitizer, a stabilizer, a catalyst, a dichroic pigment, a dye, a pigment, an antioxidant, an UV absorber, an adhesion improver and a hard coat agent. The proportion of the liquid-crystalline polysilane included in the liquid crystal material is usually 30 to 100% by mass, preferably 50 to 100% by mass and more preferably 70 to 100% by mass.

The liquid-crystalline polysilane in the mold may be crosslinked. By making the liquid-crystalline polysilane be crosslinked, the orientation of the liquid-crystalline polysilane is fixed and at the same time, it is possible to improve the heat resistance of the mold. By introducing crosslinking groups into the substituents of the liquid-crystalline polysilane, various crosslinkages become possible. A crosslinking agent may also be added to the liquid crystal material. Examples of the crosslinking group include a vinyl group, an acryl group, a methacryl group, a vinyl ether group, a cinnamoyl group, an allyl group, an acetylenyl group, a crotonyl group, an aziridinyl group, an epoxy group, an oxetanyl group, an isocyanate group, a thioisocyanate group, an amino group, a hydroxyl group, a mercapto group, a carboxylic acid group, an acyl group, a halocarbonyl group, an aldehyde group, a sulfonic acid group and a silanol group.

The raised and recessed surface of the mold for nanoimprint, formed with the liquid-crystalline polysilane, as described above, can be further transferred to another molded article, and it is also possible to use the resulting molded article as a mold for nanoimprint. By transferring, for example, to a metal molded article, a mold further excellent in the resistance against pressurization or the resistance against heating is obtained. It is possible to obtain such a metal molded article by, for example, a method for forming a metal layer by electroforming on the raised and recessed surface of the liquid crystal film. Nickel and copper are preferable as the metal from the viewpoints of the satisfactory followability to the fine raised and recessed shape of a few nanometers in size and the conductivity. Alternatively, by transferring to a resin molded article, an inexpensive mold being rich in flexibility and having a large area can be obtained. Such a resin molded article is formed, for example, with a resin selected from acrylic resin, methacrylic resin, epoxy resin, oxetane resin and silicone resin. The resins are poured into the raised and recessed surface of the liquid crystal film, the resins are cured with heat or by UV irradiation, then the cured resins are released, and thus it is possible to transfer the raised and recessed surface to resin molded articles.

It is possible to fabricate the liquid crystal film as a mold for nanoimprint, for example, by a method including: a step of forming a film of a liquid crystal material including a liquid-crystalline polysilane; and a step of obtaining as the mold for nanoimprint the film having a raised and recessed surface by forming the raised and recessed surface on the surface of the film by orienting the liquid-crystalline polysilane so as for a smectic phase to be formed and by fixing the orientation of the liquid-crystalline polysilane.

More specifically, it is possible to obtain a film (liquid crystal film) in which the orientation of the liquid-crystalline polysilane is fixed by the following method (A) or (B):
(A) a method in which a film of the liquid-crystalline polysilane is formed on an orientation substrate; by heating the film to a temperature equal to or higher than the glass transition temperature of the liquid-crystalline polysilane, the liquid-crystalline polysilane is oriented so as for the smectic phase to be formed; and then by cooling the film until the film turns into a glassy state, the orientation of the liquid-crystalline polysilane is fixed; and
(B) a method in which a film of the liquid-crystalline polysilane is formed on a substrate; the film is heated to a temperature equal to or higher than the glass transition temperature of the liquid-crystalline polysilane; the liquid-crystalline polysilane is oriented so as for the smectic liquid crystal phase to be formed by applying an external field such as a magnetic field or an electric field; and then by cooling the film until the film turns into a glassy state, the orientation of the liquid-crystalline polysilane is fixed.

As the substrate on which the film of the liquid-crystalline polysilane is formed, it is possible to use a substrate selected from a plastic film substrate, a metal substrate, a glass substrate, a ceramic substrate and a semiconductor substrate. The plastic substrate is formed of, for example, polyimide, polyamideimide, polyamide, polyetherimide, polyetheretherketone, polyetherketone, polyketonesulfide, polyethersulfone, polysulfone, polyphenylenesulfide, polyphenyleneoxide, polyethylene terephthalate, polybutylene terephthalate, polyethylene naphthalate, polyacetal, polycarbonate, polyarylate, acrylic resin, methacrylic resin, polyvinyl alcohol, polyethylene, polypropylene, poly-4-methylpentene-1 resin, cellulose-based plastic (such as triacetyl cellulose), epoxy resin, phenolic resin or a polymer liquid crystal. The metal substrate is formed of, for example, aluminum, iron or steel. The glass substrate is formed of, for example, blue sheet glass, alkali glass, alkali-free glass, borosilicate glass, flint glass or quartz glass. Examples of the semiconductor substrate include a silicon wafer.

On these substrates, for example, the following other coating films may also be disposed: organic films such as polyimide film, polyamide film and polyvinyl alcohol film; oblique vapor-deposited films such as film of silicon oxide; transparent electrodes such as an electrode of ITO (indium-tin oxide); and a metal thin film of a metal such as gold, aluminum or copper, formed by vapor deposition or sputtering.

In the case of the above-described method (A), by using a substrate subjected to orientation treatment, it is possible to set the orientation direction in the liquid crystal film so as to be in a certain direction. Additionally, in the case where a substrate subjected to no orientation treatment is used, the obtained liquid crystal film sometimes has a multi-domain phase in which the orientation directions of the respective domains are random; however, even in such a case, an intended effect is sometimes obtained.

The orientation treatment of the substrate is not particularly limited; however, examples of the orientation treatment include a rubbing method, an oblique vapor deposition method, a microgroove method, a stretched polymer film method, a LB (Langmuir-Blodgett) method, a transfer method, a light irradiation method (such as photoisomerization, photopolymerization and photolysis) and a peeling method. In particular, from the viewpoint of the easiness of the fabrication step, the rubbing method and the light irradiation method are preferable.

In the case of the above-described method (B), the liquid-crystalline polysilane is oriented in a certain direction by a method applying to the liquid crystal material spread on the substrate, electric field, magnetic field, shear stress, flow, stretching, temperature gradient or the like. The use of a substrate subjected to orientation treatment is not necessarily required.

The method for spreading the film of a liquid crystal material on the substrate is not particularly limited, and it is possible to use various heretofore known methods.

In the case where the liquid crystal material is spread between two sheets of substrates, the liquid crystal material may be injected into a cell having two sheets of substrates disposed so as to face each other, or two sheets of substrates may be laminated on both sides of the film of the liquid-crystalline polysilane. When two sheets of substrates are used, only one sheet of the two sheets may have been subjected to orientation treatment, or both of the two sheets may have been subjected to orientation treatment.

In the case where the liquid-crystalline polysilane is spread between a sheet of substrate and a gaseous phase, the liquid crystal material may be directly applied to the substrate, or a solution containing the liquid crystal material and a solvent for dissolving the liquid crystal material may be applied to the substrate. In particular, from the viewpoint of the easiness of the fabrication step, it is preferable to spread by application of a solution.

As the above-described solvent, according to the type, composition and the like of the liquid crystal material, an appropriate solvent can be properly selected. Usually the following solvents and the mixed solvents of the following solvents are used as the solvents for dissolving the liquid crystal material: aliphatic hydrocarbons such as pentane, hexane and heptane; halogenated hydrocarbons such as chloroform, dichloromethane, carbon tetrachloride, dichloroethane, tetrachloroethane, trichloroethylene, tetrachloroethylene, chlorobenzene and ortho-dichlorobenzene; phenols such as phenol and para-chlorophenol; aromatic hydrocarbons such as benzene, toluene, xylene, methoxybenzene and 1,2-dimethoxybenzene; alcohols such as isopropyl alcohol and tert-butyl alcohol; glycols such as glycerin, ethylene glycol and triethylene glycol; glycol ethers such as ethylene glycol monomethyl ether, diethylene glycol dimethyl ether, ethyl cellosolve and butyl cellosolve; acetone, methyl ethyl ketone, cyclohexanone, γ-butyrolactone, dioxane, diethyl ether, ethyl acetate, 2-pyrrolidone, N-methyl-2-pyrrolidone, pyridine, triethylamine, tetrahydrofuran, dimethylformamide, dimethylacetamide, dimethyl sulfoxide, acetonitrile, butyronitrile and carbon disulfide. To the solution, a surfactant may be added, where necessary, for the purpose of adjusting the surface tension, improving the coatability and achieving others.

The concentration of the liquid crystal material in the above-described solution can be appropriately adjusted according to the factors such as the type and the solubility of the liquid-crystalline polysilane used, and the thickness of the produced liquid crystal film, and is usually in a range from 0.5 to 50% by mass and preferably in a range from 1 to 30% by mass.

The coating method is not particularly limited; however, it is possible to use the coating methods such as spin coating, roll coating, print coating, dipping and pulling-up, curtain coating, Mayer bar coating, doctor blade coating, knife coating, die coating, gravure coating, microgravure coating, offset gravure coating, rip coating and spray coating. By removing the solvent, where necessary, after coating, it is possible to spread the liquid-crystalline polysilane as a uniform layer on the substrate.

The method for orienting the liquid-crystalline polysilane, so as for the smectic phase to be formed, in the film of the liquid-crystalline polysilane is not particularly limited. For example, when the spreading of the liquid crystal material is performed at a temperature at which the liquid-crystalline polysilane is capable of forming the smectic phase, the intended liquid crystal phase is sometimes formed at the same time as the spreading of the liquid crystal material. Additionally, by once heating the spread liquid-crystalline polysilane to a temperature higher than the temperature at which the smectic phase is formed, for example, the nematic phase or the isotropic phase is made to develop, and then the liquid-crystalline polysilane is cooled to the temperature at which the smectic phase develops, and thus, it is also possible to orient the liquid crystal material. In either of these cases, the liquid-crystalline polysilane is oriented at a temperature equal to or higher than the glass transition temperature of the liquid-crystalline polysilane.

When the liquid-crystalline polysilane is oriented, it is possible, where necessary, to align the orientation direction in a specific direction. It is possible to perform this control, for example, by using one or more sheets of substrates subjected to orientation treatment.

Specifically, for example, by using two rubbing polyimide glass plates or the like as the above-described cell for injecting the liquid-crystalline polysilane, it is possible to make the orientation direction to be in a specific direction. Also by laminating the liquid-crystalline polysilane with two sheets of a plastic film subjected to orientation treatment or the like, it is possible to make the orientation direction to be in a specific direction.

By cooling the liquid-crystalline polysilane oriented, so as for the smectic phase to be formed, at a temperature equal to or higher than the glass transition temperature, down to the temperature at which the liquid-crystalline polysilane turns into a glassy state, it is possible to fix the orientation of the liquid crystal material while maintaining the glassy state to prevent the liquid crystal material from turning into a crystalline state. The cooling means is not particularly limited; it is possible to perform an intended cooling sufficient to fix the orientation only by transferring the liquid crystal material from the heating atmosphere in the spreading step or the orientation step, to the atmosphere at a temperature equal to or lower than the glass transition temperature such as the atmosphere at room temperature. For the purpose of enhancing the production efficiency or the like, forced cooling such as air cooling or water cooling may also be performed.

By forming a metal molded article on the obtained raised and recessed surface of the liquid crystal film, a metal molded article having a raised and recessed surface formed by transferring from the raised and recessed surface of the liquid crystal film may also be obtained. The metal molded article is released from the liquid crystal film, and can be suitably used as a mold for nanoimprint. It is possible to obtain a metal molded article by a method for forming a metal layer, for example, by electroforming. By forming a resin molded article on the obtained raised and recessed surface of the liquid crystal film, a resin molded article having a raised and recessed surface formed by transferring from the raised and recessed structure of the liquid crystal film may also be obtained. The resin molded article is released from the liquid crystal film, and can be suitably used as a mold for nanoimprint. It is possible to obtain the resin molded article by a method for forming a cured resin layer, for example, by thermal curing or UV curing.

By the so-called nanoimprint method, described above, utilizing the transfer from the raised and recessed surface of the mold for nanoimprint, it is possible to process the surface of various materials. It is possible to use the mold according to the present embodiment for any of the thermal nanoimprint method, the photo-nanoimprint method and the room-temperature nanoimprint method. For example, a member for use in transfer having a roll, and the film-like mold for nanoimprint according to the present embodiment wound around the circumference surface of the roll are prepared, and by the method of continuously pressing the member to the surface of a lengthy article to be processed, it is possible to continuously process, with the mold for nanoimprint, the surface of the lengthy article to be processed.

It is also possible to apply the liquid crystal film according to the present embodiment, by taking advantage of the fine raised and recessed surface thereof, to the usage as other than a mold. For example, it is possible to constitute an optical element by using a liquid crystal film. Specifically, it is possible to obtain an optical element of the present invention by using the liquid crystal film as it is, or where necessary, by appropriately processing the liquid crystal film. For example, when a liquid crystal film is formed on a substrate, the liquid crystal film can also be used as an optical element by releasing the liquid crystal film, or can also be used as an optical element as it is formed on the substrate, and an optical element can also be obtained by laminating the liquid crystal film on another substrate. Additionally, an optical element may have a plurality of layers of films having the same or different properties.

It is also possible to fabricate a wire-grid polarizer by vapor-depositing a metal on the raised and recessed surface of the liquid crystal film according to the present embodiment, and by selectively removing the metal vapor-deposited on the raised portions or the recessed portions of the raised and recessed surface by using a method such as the lift off method.

The another substrate constituting an optical element is not particularly limited. For example, plastic substrates of polyimide, polyamideimide, polyamide, polyetherimide, polyetheretherketone, polyetherketone, polyketonesulfide, polyethersulfone, polysulfone, polyphenylenesulfide, polyphenyleneoxide, polyethylene terephthalate, polybutylene terephthalate, polyethylene naphthalate, polyacetal, polycarbonate, polyarylate, acrylic resin, methacrylic resin, polyvinyl alcohol, polyethylene, polypropylene, poly-4-methylpentene-1 resin, cellulose-based plastics such as triacetyl cellulose, epoxy resin and phenolic resin; the glass substrate; the ceramic substrate; paper; metal plates; and other optical elements such as a polarizing plate, a retardation plate, a reflection plate and a diffuser plate, can be used. It is possible to use the liquid crystal film of the present invention as an element in which the helical axis is still specified, without occurrence of the orientation disturbance and the like, even when the substrate subjected to the orientation treatment is removed after obtaining the liquid crystal film in which the direction of the helical axis is specified to be a certain direction by using the substrate subjected to orientation treatment.

For the purpose of protecting the surface, increasing the strength, improving the environmental reliability and achieving others, it is also possible to dispose, where necessary, for example on the liquid crystal film, the layers such as a protective layer and a hard coat layer formed of the films such as the above-described transparent plastic film.

### Examples

Hereinafter, the present invention is described more specifically with reference to Examples. However, the present invention is not limited to following Examples. In Examples, the following apparatuses were used.
X-Ray diffractometer: RU 200 BH manufactured by Rigaku Corp.
Atomic force microscopes: 5500 manufactured by Agilent Technologies Inc., E-Sweep manufactured by SII Nanotechnologies Inc.
DSC: DSC7 differential calorimeter manufactured by Perkin-Elmer Corp.
Optical microscope: BX-50 manufactured by Olympus Corp., equipped with a hot stage (Mettler EP90HT)

### Synthesis of Liquid-crystalline Polysilane

Dichlorosilane having a 2-methylbutyl group and an n-decyl group was polycondensed by using sodium metal in toluene at 120°C, and thus the liquid-crystalline polysilane represented by the following chemical formula (1a) was synthesized. In formula (1a), n represents a positive integer. To the toluene solution of the polymer in which the synthesis step was completed, first a small amount of isopropyl alcohol was added, and thus, the high molecular weight component was precipitated. The produced precipitate was centrifugally separated, filtered off by pressure filtration and dried under vacuum, and thus a separated sample of the liquid-crystalline polysilane was obtained. By using the remaining solution, and by repeating the same steps while varying the added solvents, the liquid-crystalline polysilane was sequentially separated starting from the high molecular weight fraction. The added solvent was varied in the order of isopropyl alcohol, ethanol, methanol and water with the decrease of the molecular weight, and thus the liquid-crystalline polysilanes different from each other in the weight average molecular weight Mw and the molecular weight distribution Mw/Mn were prepared. The phase transition temperatures of the obtained liquid-crystalline polysilanes from the columnar phase (Col) to the smectic phase A (SmA), from the smectic phase A (SmA) to the nematic phase (N) and from the nematic phase (N) to the isotropic phase (I) were examined with microscopic observation or with DSC. The weight average molecular weight Mw, the molecular weight distribution Mw/Mn and the phase transition temperatures of each of the liquid-crystalline polysilanes are shown in Table 1. In the table, the blank spaces for the phase transition temperatures show that no definite phase transitions were identified. Of the phase transition temperatures, the numerical values shown in parentheses are the temperatures measured with DSC.

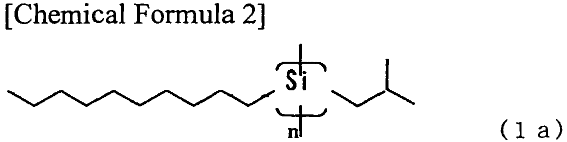

### Preparation of Thin Films

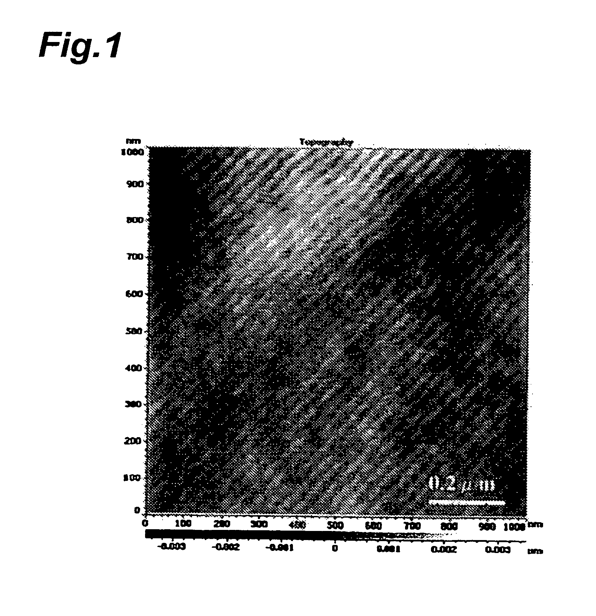

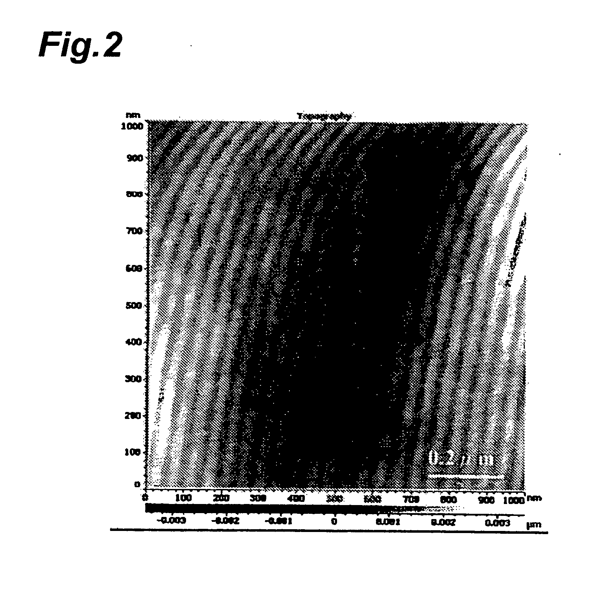

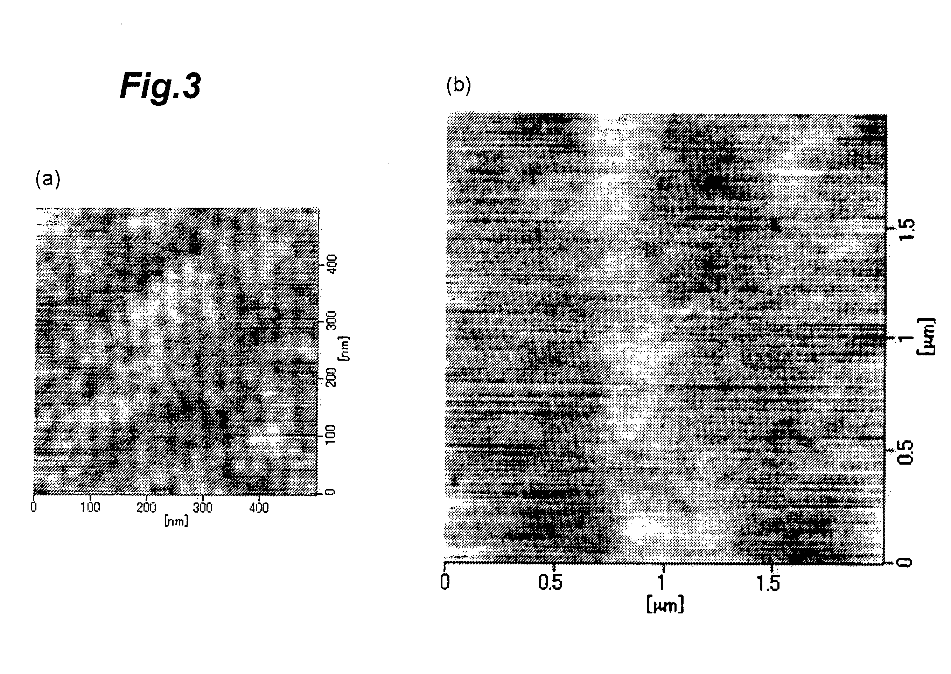

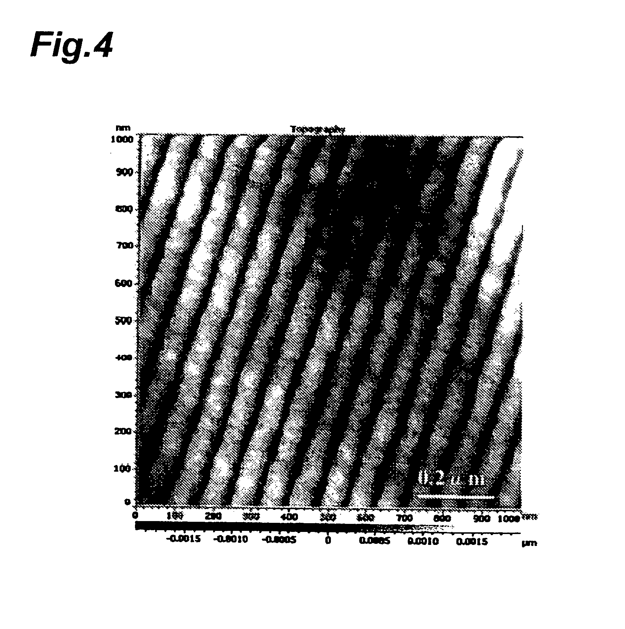

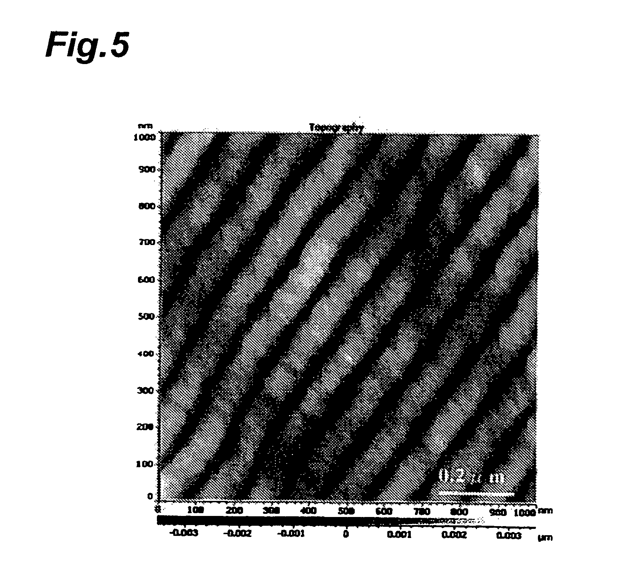

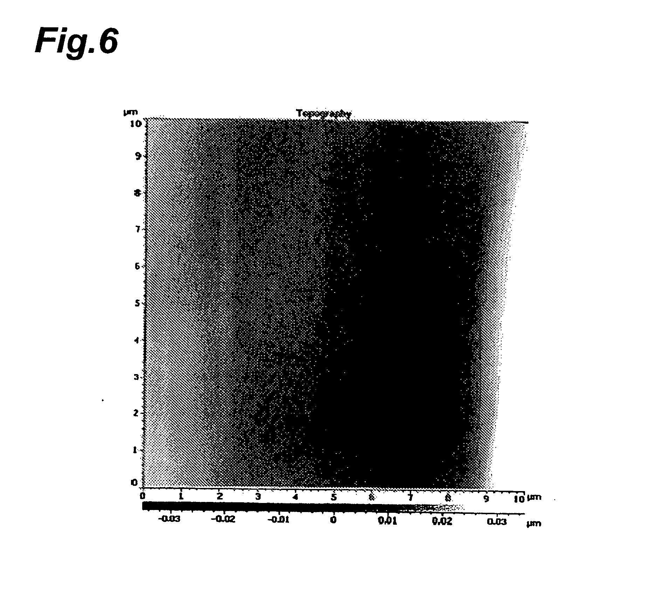

By using each of the liquid-crystalline polysilanes, in the same procedure as in Example 4 or 13 presented below, a thin film in which the uniformly oriented smectic phase A was fixed was prepared, and the surface shape and condition of the thin film was examined with an atomic force microscope (AFM) or small angle X-ray scattering (SAXS). In the surface of any of the thin films, it was verified that a raised and recessed surface having a grid shape in which a plurality of grooves were regularly aligned was formed. Figures 1, 2, 3, 4, 5 and 6 are the atomic force micrographs of the surfaces of the thin films prepared in Examples 7, 8, 9, 11, 12 and 13, respectively.

### (Example 4)

The liquid-crystalline polysilane of No. M-23.2 was dissolved in chloroform to prepare a coating solution. The coating solution was applied by spin coating onto the polyimide film placed on a 20-cm square glass substrate and subjected to rubbing treatment. The coating film was dried, and thus a thin film (thickness: about 5 µm) of the liquid-crystalline polysilane was obtained. The thin film was heat treated at 120°C for 1 hour and then rapidly cooled to room temperature, and thus a thin film in which a uniformly oriented smectic A phase was fixed was able to be obtained. The surface shape and condition of the air-facing interface of the obtained thin film was observed with an atomic force microscope, and it was verified that a raised and recessed surface having a grid shape in which a plurality of grooves were regularly aligned with a pitch of about 17 nm was formed. Additionally, similarly by X-ray small angle scattering, it was verified that a raised and recessed surface having a grid shape in which a plurality of grooves were regularly aligned was formed.

### (Example 13)

The liquid-crystalline polysilane of No. M-151 was dissolved in chloroform to prepare a coating solution. The coating solution was applied by spin coating onto the polyphenylenesulfide (PPS) film subjected to rubbing treatment. The coating film was dried, and thus a thin film (thickness: about 1 µm) of the liquid-crystalline polysilane was obtained. The thin film was heat treated at 130°C for 1 hour and then rapidly cooled to room temperature, and thus a thin film in which a uniformly oriented smectic A phase was fixed was able to be obtained. The surface shape and condition of the air-facing interface of the obtained thin film was observed with an atomic force microscope (AFM), and it was verified that a raised and recessed surface having a grid shape in which a plurality of grooves were regularly aligned with a pitch of about 110 nm was formed.

**[Table 1]**

| | Liquid-crystalline polysilane | | | | | | Thin film | | |
|---|---|---|---|---|---|---|---|---|---|
| | No. | Mw | Mw/Mn | Phase transition temperature [°C] | | | Heat treatment temperature [°C] | Pitch in raised and recessed surface [nm] | |
| | | | | Col →SmA | SmA →N | N →I | | SAXS | AFM |
| Example 1 | M-13.7 | 13700 | 1.10 | | 109-101 | 120-140 | 100 | 12.9 | |
| Example 2 | M-17.1 | 17100 | 1.08 | | 128-13C | 145-160 | 110 | 16.5 | |
| Example 3 | M-20.0 | 20000 | 1.08 | | 142-146 | 160-170 | 120 | 18.5 | |
| Example 4 | M-23.2 | 23200 | 1.09 | 75 (75) | 154-156 (155) | 176-186 (180) | 120 | 20.5 | 16.7 |
| Example 5 | M-26.2 | 26200 | 1.11 | - | 163-169 | 185-195 | 130 | 22.4 | 18.4 |
| Example 6 | M-32.1 | 32100 | 1.07 | (73) | 177-179 | -186-200 (189) | 130 | 26.6 | |
| Example 7 | M-36.2 | 36200 | 1.12 | | 182-186 | 190-206 | 130 | 30.3 | 30.0 |
| Example 8 | M-57.6 | 57600 | 1.16 | (83) | 171-177 | 215-235 | 130 | | 50.2 |
| Example 9 | M-69.0 | 69000 | 1.51 | | | 218-238 | 130 | | 33.3 |
| Example 10 | M-88.3 | 88300 | 1.23 | | 187-184 | 200-220 | 130 | | 65.0 |
| Example 11 | M-119 | 119000 | 1.34 | (72) | 168-172 | 205-230 | 130 | | 75.3 |
| Example 12 | M-133 | 13300C | 1.32 | (73) | 178-183 | 210-220 | 130 | | 101.4 |
| Example 13 | M-151 | 151000 | 1.39 | (74) | 169-173 | 210-230 | 130 | | 109.6 |
| Comp. Example 1 | M-151 | 151000 | 1.39 | (74) | 169-173 | 210-230 | 200 | Flat | Flat |
| Comp. Example 2 | M-23.2 | 23200 | 1.09 | 75 (75) | 154-156 (155) | 176-186 (180) | 170 | Flat | Flat |

### (Comparative Example 1)

A thin film of the liquid-crystalline polysilane was obtained by the same procedure as in Example 13 except that the heat treatment of the thin film was performed at 200°C. The surface shape and condition of the air-facing interface of the obtained thin film was observed with an atomic force microscope, and was found to be flat, and the formation of the grid shape as observed in Examples was not found.

### (Comparative Example 2)

A thin film of the liquid-crystalline polysilane was obtained by the same procedure as in Example 4 except that the heat treatment was performed at 170°C. The surface shape and condition of the air-facing interface of the obtained thin film was observed with an atomic force microscope and was found to be flat, and the formation of the grid shape as observed in Examples was not found.

### Transfer of the Raised and Recessed Surface

### (Example 14)

Onto the surface of the thin film, on the PPS film, of the liquid-crystalline polysilane, obtained in Example 13, a commercial UV-curable adhesive (UV-3400, manufactured by Toagosei Co., Ltd.) was applied, and a triacetyl cellulose (TAC) film was laminated thereover. Then, from the side of the TAC film, UV irradiation was performed to cure the adhesive, the PEN film and the thin film of the liquid-crystalline polysilane were released, and thus a laminate having a configuration of adhesive layer/TAC film was obtained. The surface shape and condition of the adhesive layer was observed with an atomic force microscope, and it was found that a raised and recessed surface having a grid shape in which a plurality of grooves were regularly aligned with a pitch of about 110 nm was formed. In other words, it was verified that the raised and recessed surface of the thin film of the liquid-crystalline polysilane, obtained in Example 13, was accurately transferred to the adhesive layer.

## Claims

1. A mold for nanoimprint containing a liquid-crystalline polysilane and having a raised and recessed surface formed by the formation of a smectic phase due to the orientation of the liquid-crystalline polysilane, wherein the pitch of the raised and recessed surface is 1 to 2000 nm.

2. The mold for nanoimprint according to claim 1, wherein the weight-average molecular weight of the liquid-crystalline polysilane is 10000 or more.

3. The mold for nanoimprint according to claim 1 or 2, wherein the liquid-crystalline polysilane forms a smectic phase by undergoing an orientation while forming a helical structure.

4. A mold for nanoimprint being a metal molded article or a resin molded article having a raised and recessed surface transferred from the raised and recessed surface of the mold for nanoimprint according to any one of claims 1 to 3.

5. A method for fabricating a mold for nanoimprint comprising:
a step of forming a film containing a liquid-crystalline polysilane; and
a step of obtaining as the mold for nanoimprint the film having a raised and recessed surface having a pitch of 1 to 2000 nm by forming the raised and recessed surface on the surface of the film by orienting the liquid-crystalline polysilane so that a smectic phase is formed and by fixing the orientation of the liquid-crystalline polysilane.

6. A method for fabricating a mold for nanoimprint comprising:
a step of forming a film comprising a liquid-crystalline polysilane;
a step of forming a raised and recessed surface having a pitch of 1 to 2000 nm on the surface of the film by orienting the liquid-crystalline polysilane so that a smectic phase is formed and by fixing the orientation of the liquid-crystalline polysilane; and
a step of obtaining as the mold for nanoimprint a metal molded article or a resin molded article having the raised and recessed surface formed by the transfer from the raised and recessed surface on the surface of the film, by forming the metal molded article or the resin molded article on the raised and recessed surface of the film.

7. A processing method for processing a material by the transfer from the raised and recessed surface of the mold for nanoimprint according to any one of claims 1 to 4.

## Patentansprüche

1. Form für den Nanoimprint bzw. Nanoimprintform enthaltend ein flüssigkristallines Polysilan und mit einer erhöhten und vertieften Oberfläche, geformt durch die Bildung einer smektitischen Phase durch die Orientierung des flüssigkristallinen Polysilans, wobei der Abstand der erhöhten und vertieften Oberfläche 1 bis 2000 nm beträgt.

2. Nanoimprintform nach Anspruch 1, wobei das gewichtsgemittelte Molekulargewicht des flüssigkristallinen Polysilans 10000 oder mehr beträgt.

3. Nanoimprintform nach Anspruch 1 oder 2, wobei das flüssigkristalline Polysilan eine smetitische Phase bildet, indem es einer Orientierung unterworfen wird, während es eine schraubenförmige Struktur bildet.

4. Nanoimprintform, welche ein geformter Metallgegenstand oder ein geformter Harzgegenstand mit einer erhöhten und vertieften Oberfläche ist, welche von der erhöhten und vertieften Oberfläche der Nanoimprintform nach einem der Ansprüche 1 bis 3 übertragen ist.

5. Verfahren zur Herstellung einer Form für den Nanoimprint, umfassend:
einen Schritt des Bildens eines Films enthaltend ein flüssigkristallines Polysilan; und
einen Schritt des Erhaltens, als die Nanoimprintform, des Filmes mit einer erhöhten und vertieften Oberfläche mit einem Abstand von 1 bis 2000 nm, durch Bilden der erhöhten und vertieften Oberfläche auf der Oberfläche des Films durch Orientieren des flüssigkristallinen Polysilans, so dass eine smetitische Phase gebildet wird und durch Fixieren der Orientierung des flüssigkristallinen Polysilans.

6. Verfahren zur Herstellung einer Form für den Nanoimprint, umfassend:
einen Schritt des Bildens eines Films umfassend ein flüssigkristallines Polysilan;
einen Schritt des Bildens einer erhöhten und vertieften Oberfläche mit einem Abstand von 1 bis 2000 nm auf der Oberfläche des Films durch Orientieren des flüssigkristallinen Polysilans, so dass eine smektitische Phase gebildet wird und durch Fixieren der Orientierung des flüssigkristallinen Polysilans; und
einen Schritt des Erhaltens, als die Nanoimprintform, eines geformten Metallgegenstands oder eines geformten Harzgegenstands mit der erhöhten und vertieften Oberfläche, gebildet durch die Übertragung von der erhöhten und vertieften Oberfläche auf die Oberfläche des Films; durch Bilden des geformten Metallgegenstandes oder des geformten Harzgegenstandes auf der erhöhten und vertieften Oberfläche des Films.

7. Verarbeitungsverfahren zur Bearbeitung eines Materials durch die Übertragung von der erhöhten und vertieften Oberfläche der Nanoimprintform nach einem der Ansprüche 1 bis 4.

## Revendications

1. Moule de nanoimpression contenant un polysilane en cristaux liquides et ayant une surface surélevée et en retrait formée par la formation d'une phase smectique due à l'orientation du polysilane en cristaux liquides, dans lequel le pas de la surface surélevée et en retrait est de 1 à 2000 nm.

2. Moule de nanoimpression selon la revendication 1, dans lequel le poids moléculaire moyen en poids du polysilane en cristaux liquides est supérieur ou égal à 10 000.

3. Moule de nanoimpression selon la revendication 1 ou 2, dans lequel le polysilane en cristaux liquides forme une phase smectique en étant soumis à une orientation pendant la formation d'une structure hélicoïdale.

4. Moule de nanoimpression constitué d'un objet métallique moulé ou d'un objet en résine moulée ayant une surface surélevée et en retrait transférée depuis la surface surélevée et en retrait du moule de nanoimpression selon l'une quelconque des revendications 1 à 3.

5. Procédé de fabrication d'un moule de nanoimpression comprenant :
une étape de formation d'un film contenant un polysilane en cristaux liquides ; et
une étape d'obtention en tant que moule de nanoimpression du film ayant une surface surélevée et en retrait ayant un pas de 1 à 2000 nm par formation de la surface surélevée et en retrait sur la surface du film par orientation du polysilane en cristaux liquides de façon à former une phase smectique et par fixation de l'orientation du polysilane en cristaux liquides.

6. Procédé de fabrication d'un moule de nanoimpression comprenant :
une étape de formation d'un film comprenant un polysilane en cristaux liquides ;
une étape de formation d'une surface surélevée et en retrait ayant un pas de 1 à 2000 nm sur la surface du film par orientation du polysilane en cristaux liquides de façon à former une phase smectique et par fixation de l'orientation du polysilane en cristaux liquides ; et
une étape d'obtention en tant que moule de nanoimpression d'un objet métallique moulé ou d'un objet en résine moulée ayant la surface surélevée et en retrait formée par le transfert depuis la surface surélevée et en retrait sur la surface du film, par formation de l'objet métallique moulé ou de l'objet en résine moulée sur la surface surélevée et en retrait du film.

7. Procédé de traitement pour traiter un matériau par le transfert depuis la surface surélevée et en retrait du moule pour nanoimpression selon l'une quelconque des revendications 1 à 4.
